Europäisches Patentamt

(19) European Patent Office

Office européen des brevets

(11) Numéro de publication: **0 391 810**
**A1**

(12) **DEMANDE DE BREVET EUROPEEN**

(21) Numéro de dépôt: 90420151.4

(22) Date de dépôt: 27.03.90

(51) Int. Cl.⁵: **D01F 11/12, C23C 16/54**

(30) Priorité: 04.04.89 FR 8904650

(43) Date de publication de la demande:
**10.10.90 Bulletin 90/41**

(84) Etats contractants désignés:
**AT BE CH DE DK ES FR GB GR IT LI LU NL SE**

(71) Demandeur: **CENTRE NATIONAL DE LA RECHERCHE SCIENTIFIQUE (CNRS)**
**15, Quai Anatole France**
**F-75700 Paris Cedex 07(FR)**

(72) Inventeur: **Bouix, Jean**
**16 Avenue Félix Faure**
**F-69007 Lyon(FR)**
Inventeur: **Mourichoux, Hervé**
**44 rue Racine**
**F-69100 Villeurbanne(FR)**
Inventeur: **Vincent, Christiane, née Forat**
**25 rue de Montbrillant**
**F-69003 Lyon(FR)**
Inventeur: **Vincent, Henri Jean**
**25 rue de Montbrillant**
**F-69003 Lyon(FR)**

(74) Mandataire: **Laurent, Michel et al**
**Cabinet LAURENT 20, rue Louis Chirpaz B.P. 32**
**F-69131 Ecully Cédex(FR)**

(54) **Dispositif perfectionné pour revêtir en continu une étoffe en fibres de carbone d'une couche protectrice de passivation à base de carbure.**

㊸ Dispositif perfectionné pour revêtir en continu une étoffe ou analogue en fibres de carbone d'une couche protectrice de passivation à base de carbure, comprenant:
- une enceinte étanche et résistante à la corrosion;
- un jeu de poulies respectivement de dévidage (3) et de renvidage (1) ;
- un organe (2,4) apte à maintenir l'étoffe sous une faible tension positive ;
- et un moyen (7) pour chauffer l'étoffe en défilement (10),
**caractérisé** en ce qu'il comprend en outre, entre les deux poulies (1,3), un réacteur traversé par l'étoffe (10) et à contre courant par un mélange gazeux réactionnel, constitué par un premier élément allongé creux (5), susceptible d'entourer l'étoffe en défilement, et réalisé en un matériau inerte vis-à-vis du mélange gazeux réactionnel, et par un second élément allongé creux (6) coaxial audit premier élément (5).

Applications: matériaux composites, alliages légers, industries aéronautique, automobile, etc.

FIG.1

## DISPOSITIF PERFECTIONNE POUR REVETIR EN CONTINU UNE ETOFFE EN FIBRES DE CARBONE D'UNE COUCHE PROTECTRICE DE PASSIVATION A BASE DE CARBURE.

La présente invention concerne un dispositif perfectionné pour revêtir en continu une étoffe ou analogue en fibres de carbone d'une couche protectrice de passivation à base d'un carbure.

Dans le brevet français FR-A-2 607 840, on a décrit un procédé et un dispositif susceptibles de permettre le revêtement en continu de mèches de filaments de carbone. Ce procédé repose sur l'élaboration d'une couche de carbure impliquant une réaction chimique avec le carbone des filaments et une phase gazeuse ne contenant pas de composés carbonés gazeux, permettant de la sorte d'obtenir des mèches présentant une meilleure résistance, tant à l'oxydation qu'à l'action des métaux à haute température. Ce procédé de dépot, plus connu sous l'expression anglaise "CVD réactive" ou "RCVD" (Reactive Chemical Vapour Deposition), reste toutefois limité, le substrat se présentant sous forme monodimensionnelle, en l'occurrence des mèches.

En effet, l'une des phases de ce procédé fait appel à un chauffage direct des fibres par mise sous tension électrique. De fait, le procédé et donc son dispositif de mise en oeuvre ne sont pas utilisables pour les structures bi- ou tridimensionnelles, telles que rubans, tissus ou analogues, car ils impliqueraient une tension élevée et de fait, nécessiteraient des équipements électriques de grande puissance, incompatibles avec une installation industrielle rationnelle et rentable, et qui de plus grèveraient lourdement la sécurité, notamment du personnel.

La présente invention vise à pallier ces inconvénients. Elle propose un dispositif apte à permettre le traitement en continu d'étoffes ou analogues, c'est à dire de structures bi- ou tridimensionnelles par dépot en phase gazeuse d'une couche protectrice de passivation à base de carbure.

Ce dispositif perfectionné comprend :
- une enceinte étanche et résistante à la corrosion, équipée à l'une de ses extrémités d'un orifice d'amenée du mélange gazeux réactionnel comprenant d'une part, de l'hydrogène, et d'autre part un composé volatil apte à donner un carbure réfractaire, et à l'autre extrémité un orifice de sortie des gaz ayant réagi ;
- un jeu de poulies respectivement de dévidage et de renvidage, placées dans ladite enceinte aptes à faire défiler l'étoffe ;
- un organe apte à maintenir l'étoffe sous une faible tension positive ;
- et un moyen pour chauffer l'étoffe qui défile.

La présente invention se caractérise en ce que le dispositif comprend en outre, entre les deux poulies, un réacteur traversé par l'étoffe et à contre courant par le mélange gazeux réactionnel, constitué par un premier élément allongé creux, susceptible d'entourer l'étoffe en défilement, et réalisé en un matériau inerte vis-à-vis du mélange gazeux réactionnel, et par un second élément allongé creux coaxial audit premier élément.

En d'autres termes, la présente invention consiste à muni un dispositif de traitement en continu par la méthode dite "RCVD" d'un réacteur particulier constitué en fait de deux éléments coaxiaux destinés à permettre le traitement d'étoffes bi- ou tridimensionnelles.

Avantageusement, en pratique :
- le rouleau de dévidage est monté fou en rotation, alors que le rouleau de renvidage est moteur ;
- l'étoffe à traiter est dévidée et renvidée à plat par passage sur des embarrages ;
- les deux éléments constitutifs du réacteur sont coaxiaux et parallèlépipédiques ou cylindriques, en fonction des dimensions de l'étoffe à traiter ;
- le premier élément du réacteur forme suscepteur et est réalisé en graphite passivé préalablement par le mélange gazeux réactionnel ;
- le deuxième élément du réacteur est résistant à la chaleur et à la corrosion et est réalisé en un matériau choisi dans le groupe constitué par la silice et l'alumine.

La manière dont l'invention peut être réalisée et les avantages qui en découlent ressortiront mieux de l'exemple de réalisation qui suit, donné à titre indicatif mais non limitatif, à l'appui des figures annexées dans lesquelles :

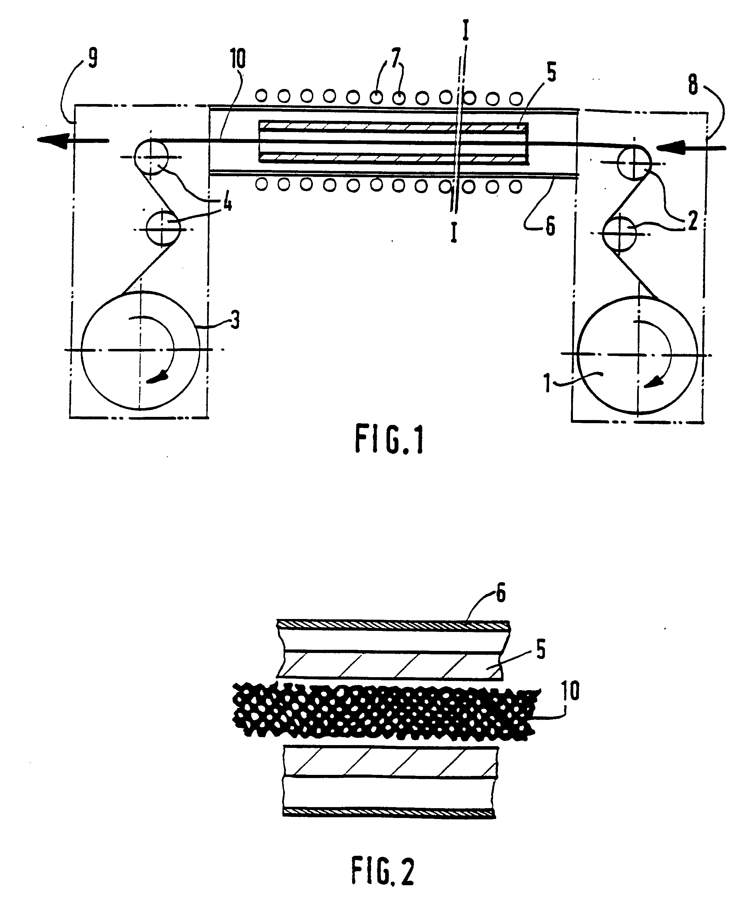

- la figure 1 est une vue en coupe longitudinale du dispositif conforme à l'invention ;
- la figure 2 est une coupe transversale selon la ligne I-I de la figure 1.

L'exemple qui suit se rapporte au traitement d'une étoffe se présentant sous la forme d'un tricot cylindrique d'un centimètre de diamètre, constitué de 36 mèches de 2000 filaments unitaires chacune. Toutefois, il est bien entendu que le dispositif conforme à la présente invention peut tout à fait être adapté au traitement d'éléments textiles bi- ou tridimensionnels, c'est-à-dire à des étoffes en fibres de carbone comportant deux de ses dimensions respectivement la largeur et la longueur, prépondérantes par rapport à la troisième dimension, en l'occurrence l'épaisseur. De la sorte, ce dispositif s'applique tout à fait au traitement de tissus, tricots, grilles, tresses, gazes, rubans, ainsi qu'aux tricotéscousus.

Conformément à l'invention, l'enceinte de traitement comporte un réacteur, constitué d'un premier élément creux et allongé (5), dénommé suscepteur, et d'un second élément (6), coaxial et externe par rapport à ce dernier. Le dit second élément (6) est réalisé avantageusement en silice, voire en alumine, afin de pouvoir résister efficacement à la chaleur et la corrosion.

Dans le cas de l'exemple décrit, le suscepteur (5) est de forme cylindrique, dont le diamètre interne est de quatorze millimètres, et dont la longueur est égale à quarante centimètres. Il est réalisé en graphite.

De manière commode, le suscepteur (5) et ledit second élément (6) constitutif du réacteur sont coaxiaux et parallélépipèdiques, notamment dans le cas de traitement d'étoffes de dimensions importantes.

Le suscepteur (5) est alors passivé, c'est-à-dire rendu chimiquement inerte vis-à-vis des réactifs gazeux utilisés par RCVD, par traitement pendant une durée d'environ deux jours par le mélange gazeux approprié. Selon la nature du carbure déposé sur l'étoffe à traiter (10), principalement choisi dans le groupe composé par le carbure de silicium (SiC), le carbure de titane (TiC), voire le carbure de bore ($B_4C$), le mélange approprié est alors constitué respectivement de $SiCl_4$-$H_2$ de $TiCl_4$-$H_2$, ou de $BCl_3$-$H_2$, et ce à une température de 1500° C.

Le suscepteur (5) est principalement destiné à concentrer la chaleur générée par un dispositif de chauffage (7) au niveau de l'étoffe (10) en défilement.

Avant dépôt sur l'étoffe de la couche protectrice de passivation à base de carbure, celle-ci subit préalablement une phase de désensimage consistant, de manière tout à fait traditionnelle, en un chauffage à 800° C sous vide.

On passe alors à la phase proprement dite de formation de la couche de passivation de carbures sur l'étoffe (10). L'étoffe (10) est stockée au préalable sur une bobine de dévidage (3) montée folle en rotation. Elle est dévidée à plat par passage sur des embarrages (4), puis dans le réacteur constitué respectivement par le suscepteur (5) et la paroi externe du réacteur proprement dit (6).

Après passage dans le réacteur, l'étoffe est récupérée à plat par des embarrages (2), puis renvidée sur une bobine de renvidage (1) qui elle, est moteur.

La vitesse de défilement est de l'ordre de 0,5 mètre/heure. De la sorte, la durée de contact de l'étoffe avec le mélange réactionnel gazeux traversant le réacteur est de l'ordre de vingt minutes. De fait, cette durée de contact est ajustée en fonction des débits gazeux et de la vitesse de défilement de l'étoffe dans le réacteur.

Le mélange réactionnel gazeux, pénètre dans le réacteur par une orifice d'amenée (8) à la pression atmosphérique, circule à contre sens de l'étoffe dans le réacteur. Les gaz ayant réagi, ressortent de l'enceinte par un orifice de sortie (9).

L'enceinte du réacteur est chauffée par induction hautes fréquences au moyen des spires (7). Celles-ci entourent le réacteur (6), notamment au niveau du suscepteur (5). La température de l'enceinte est systématique ment portée au delà de 1000° C, le choix de celle-ci étant dicté par la nature du revêtement désiré.

Dans le cas de la formation d'une couche de passivation en carbure de silicium, on introduit dans le réacteur un mélange constitué par de l'hydrogène, du chlorure de silicim ($SiCl_4$) et de l'argon. Le débit respectif de chacun de ces trois gaz est de 225 cm³/min, 100 cm³/min et 650 cm³/min. Pendant toute la durée du traitement, l'étoffe est maintenue en légère tension positive par l'intermédiaire des embarrages (2,4) et des poulies de dévidage et de renvidage (1,3), et ce afin d'éviter tout flottement. La température du suscepteur (5) étant maintenue supérieure ou égale à 1500° C.

Dans le cas de la formation d'une couche de passivation de carbure de titane, on introduit un mélange gazeux réactionnel constitué respectivement d'hydrogène avec un débit de 2400 cm³/min et de chlorure de titane ($TiCl_4$) avec un débit de l'ordre de 40 cm³/min. La température du suscepteur est maintenue supérieure ou égale à 1100° C.

Dans le cas de la formation d'une couche de passivation en carbure de bore ($B_4C$), on introduit dans l'enceinte un mélange réactionnel constitué d'une part, d'hydrogène avec un débit de 75 cm³/min, et de chlorure de bore ($BCl_3$) avec un débit de 50 cm³/min. La température du suscepteur est maintenue supérieure ou égale à 1300° C.

On obtient de la sorte une étoffe dans laquelle les techniques de caractérisation, notamment la diffraction aux rayons X, montrent que le revêtement de la tresse constitutive de l'étoffe traitée par les carbures, est légèrement cristallisé. L'imagerie X et la microscopie électronique à balayage montrent que le revêtement est uniforme ; en effet, aucun effet d'ombre ou de soudure n'a pu être mis en évidence y compris au niveau du croi sement des fibres. Ce revêtement épouse de la sorte la forme initiale des filaments constitutifs de la tresse. L'étoffe conserve de fait sa souplesse initiale. L'analyse chimique permet d'évaluer l'épaisseur de la couche à environ cinquante nanomètres.

Dans le cas de dimensions suffisamment importantes par rapport aux dimensions du réacteur, le suscepteur (5) n'est pas nécessaire. En effet, on observe des résultats sensiblement équivalents dans ce cas là, selon que l'on utilise ou non un suscepteur.

De la sorte, le dispositif conforme à l'invention permet de traiter des étoffes réalisées en fibres de carbone, avec des débits largement augmentés par rapport aux dispositifs connus à ce jour dans lesquels, le traitement d'étoffes bi- ou tridimensionnelles n'était pas possible. De la sorte,les étoffes ainsi traitées peuvent-elles avoir de multiples applications, notamment dans l'élaboration de matériaux composites ou d'alliages légers ou de céramiques. Ainsi, ces étoffes traitées peuvent être utilisées avec succès dans les industries aéronautiques, aérospatiales, nucléaires ou automobiles, etc. .

## Revendications

1/ Dispositif perfectionné pour revetir en continu une étoffe ou analogue en fibres de carbone d'une couche protectrice de passivation à base de carbure,comprenant:
- une enceinte étanche et résistante à la corrosion, équipée à l'une de ses extrémités d'un orifice d'amenée (8) d'un mélange gazeux réactionnel comprenant d'une part, de l'hydrogéne, et d'autre part un composé volatil apte à donner un carbure réfractaire, et à l'autre extrémité un orifice de sortie (9) des gaz ayant réagi ;
- un jeu de poulies respectivement de dévidage (3) et de renvidage (1), placées dans ladite enceinte pour faire défiler l'étoffe (10) ;
- un organe (2,4) apte à maintenir l'étoffe sous une faible tension positive ;
- et un moyen (7) pour chauffer l'étoffe en défilement (10),
**caractérisé** en ce qu'il comprend en outre, entre les deux poulies (1,3), un réacteur traversé par l'étoffe (10) et à contre courant par le mélange gazeux réactionnel, constitué par un premier élément allongé creux (5), susceptible d'entourer l'étoffe en défilement, et réalisé en un matériau inerte vis-à-vis du mélange gazeux réactionnel, et par un second élément allongé creux (6) coaxial audit premier élément (5).

2/ Dispositif perfectionné selon la revendication 1, caractérisé en ce que le rouleau de dévidage (1) est monté fou en rotation, alors que le rouleau de renvidage (3) est moteur.

3/ Dispositif perfectionné selon l'une des revendications 1 et 2, caractérisé en ce que l'étoffe dévidée est renvidée à plat par passage sur des embarrages (2,4).

4/ Dispositif perfectionné selon l'une des revendications 1 à 3, caractérisé en ce que les deux éléments (5,6) constitutifs du réacteur sont coaxiaux et parallèlépipédiques ou cylindriques.

5/ Dispositif perfectionné selon l'une des revendications 1 à 4, caractérisé en ce que le premier élément (5) constitutif du réacteur, forme suscepteur et est réalisé en graphite passivé par le mélange gazeux réactionnel.

6/ Dispositif perfectionné selon l'une des revendications 1 à 5, caractérisé en ce que le deuxième élément du réacteur (6), résistant à la chaleur et à la corrosion, est réalisé en un matériau choisi dans le groupe constitué par la silice et l'alumine. .

FIG.1

FIG.2

**Office européen des brevets**

# RAPPORT DE RECHERCHE EUROPEENNE

Numero de la demande

EP 90 42 0151

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | DE-A-3 424 166 (FITZER)<br>* Figure 2 *<br>--- | 1-3 | D 01 F 11/12<br>C 23 C 16/54 |
| A | US-A-4 263 336 (THOMPSON et al.)<br>* Figure 2; colonne 3, lignes 20-22,45-48 *<br>--- | 4-6 | |
| A,D | FR-A-2 607 840 (CNRS)<br>----- | | |

| | |
|---|---|
| | **DOMAINES TECHNIQUES RECHERCHES (Int. Cl.5)** |
| | C 23 C<br>D 01 F |

**Le présent rapport a été établi pour toutes les revendications**

| Lieu de la recherche | Date d'achèvement de la recherche | Examinateur |
|---|---|---|
| LA HAYE | 12-07-1990 | PATTERSON A.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)